Europäisches Patentamt

European Patent Office

Office européen des brevets

(19)

(11) Numéro de publication: **0 032 324**
**B1**

(12) **FASCICULE DE BREVET EUROPEEN**

(45) Date de publication du fascicule du brevet: **10.11.82**

(51) Int. Cl.³: **G 11 B 5/45, H 03 G 3/20**

(21) Numéro de dépôt: **80401421.5**

(22) Date de dépôt: **06.10.80**

(54) Procédé pour commander le gain des circuits amplifiant les signaux délivrés par une tête de lecture associée à un support d'informations et dispositif pour le mettre en oeuvre.

(30) Priorité: **19.12.79 FR 7931080**

(43) Date de publication de la demande:
**22.07.81 Bulletin 81/29**

(45) Mention de la délivrance du brevet:
**10.11.82 Bulletin 82/45**

(84) Etats contractants désignés:
**DE GB IT NL**

(56) Documents cités:
FR - A - 1 340 204
FR - A - 2 424 668
US - A - 3 660 821
US - A - 3 879 674

IBM TECHNICAL DISCLOSURE BULLETIN, vol. 21, no. 9, février 1979 New York US J. LEWKOWICZ et al.: "Automatic gain control with equalizer", pages 3569—3570

IBM TECHNICAL DISCLOSURE BULLETIN, vol. 11, no. 2, juillet 1968, New York US F. A. HELLWARTH et al.: "Automatic measure and hold level control" pages 163—164

(73) Titulaire: **COMPAGNIE INTERNATIONALE POUR L'INFORMATIQUE CII - HONEYWELL BULL (dite CII-HB)**
**94, avenue Gambetta**
**F-75020 Paris (FR)**

(72) Inventeur: **Lequien, Jean**
**94, avenue Gambetta**
**F-75020 - Paris (FR)**

(74) Mandataire: **Gouesmel, Daniel**
**94, avenue Gambetta**
**F-75020 Paris (FR)**

Courier Press, Leamington Spa, England.

Procédé pour commander le gain des circuits amplifiant les signaux délivrés par une tête de lecture associée à un support d'informations et dispositif pour le mettre en oeuvre.

La présente invention concerne un procédé pour commander le gain des circuits amplifiant les signaux délivrés par une tête de lecture des informations contenues sur un support et le dispositif pour le mettre en oeuvre.

Elle est plus particulièrement applicable aux circuits électroniques de lecture associés aux têtes de lecture des mémoires à disques utilisées dans les systèmes de traitement de l'information.

Dans de tels systèmes, on utilise de plus en plus fréquemment les mémoires à disques magnétiques en raison de leur capacité de stockage et du temps relativement court mis par les têtes magnétiques d'écriture-lecture à accéder à une informatior contenue en un point quelconque des disques à partir du moment où elles ont reçu l'ordre d'accéder à cette information.

On sait que les disques magnétiques portent les informations sous forme codée, sur des pistes d'enregistrement concentriques, circulaires dont la largeur n'excède pas quelques centièmes de millimètres et qui sont disposées sur leurs deux faces.

Les codes les plus fréquemment utilisés sont les codes binaires.

On repère les pistes en leur affectant un numéro d'ordre $j$, $j$ étant un nombre entier variant de 0 à N—1, N étant le nombre total de pistes d'enregistrement.

Pour permettre la lecture ou l'écriture des informations, les têtes magnétiques sont disposées de chaque côté des disques, à une distance de quelques dixièmes de microns de ceux-ci.

Les disques magnétiques sont entraînés par un moteur électrique à vitesse de rotation constante.

On considère une mémoire à disques ne contenant qu'un nombre limité de ceux-ci, et, pour simplifier, une seule face d'un disque D. Le plus souvent, on associe à cette dernière une seule tête magnétique TEL de lecture-écriture. Il est clair que la description qui suit est valable pour toutes les faces des disques, quel que soit le nombre de têtes associées à chacune de celles-ci.

Les informations sont alors enregistrées sur la dite face de la manière suivante. Un maximum de place est réservé à l'enregistrement des informations ou données destinées à être traitées par le système de traitement de l'information auquel ces mémoires appartiennent, ces données étant appelées "données à traiter" pour simplifier. Un minimum de place est réservé notamment à l'enregistrement d'informations de repérage des pistes, à savoir les adresses de celles-ci (l'adresse d'une piste est l'expression codée du numéro d'ordre $j$ de celle-ci) et les informations nécessaires à l'asservissement de position au-dessus des pistes de la tête TEL associée à cette face. Celle-ci lit ou écrit aussi bien les "données à traiter" que les informations de repérage des pistes.

Dans la pratique courante, ainsi qu'il est décrit dans la demande de brevet déposée le 19 Octobre 1978 sous le No. 78.29847 par la Compagnie Demanderesse sous le titre "Mode d'écriture d'informations sur un support d'enregistrement magnétique", les informations contenues sur chaque face du disque sont de préférence réparties sur des secteurs circulaires, égaux et adjacents $S_0$, $S_1$, ..., $S_i$, ..., $S_{n-1}$. Habituellement une face de disque est divisée en plusieurs dizaines de secteurs (le plus souvent 40 à 50).

Lorsque la face du disque magnétique défile devant la tête magnétique qui lui est associée, le secteur $S_0$ est lu par la tête avant le secteur $S_1$, le secteur $S_1$ avant le secteur $S_2$ et ainsi de suite. On dit alors que le secteur $S_0$ précède le secteur $S_1$, que le secteur $S_1$ précède le secteur $S_2$, que le secteur $S_i$ précède le secteur $S_{i+1}$ (ou encore que le secteur $S_{i+1}$ suit le secteur $S_i$) etc.

Plus généralement, lorsqu'on considère deux informations $I_{k-1}$ et $I_k$ sui se suivent sur une piste de numéro d'ordre $j$ de ladite face, on dit que l'information $I_{k-1}$ précède l'information $I_k$ si elle est lue par la tête TEL avant cette dernière, ou encore que l'information $I_k$ suit l'information $I_{k-1}$; le raisonnement est également valable pour plusieurs groupes d'informations $G_k$ et $G_{k-1}$.

Chaque secteur $S_i$ est divisé en deux aires inégales. L'aire la plus grande comprend les "données à traiter" tandis que l'aire la plus petite comprend les informations de repérage des pistes. Pour chaque secteur $S_i$, l'aire la plus petite est divisée en plusieurs zones appelées "zones de référence" en nombre au moins égal à celui des pistes, chaque piste de numéro d'ordre $j$ étant associée à une première zone dénommée $ZRP_{ij}$ et à une seconde $ZRP_{i(j+1)}$. Ces deux zones sont appelées "zones voisines". La frontière entre celles-ci est confondue avec l'axe de symétrie circulaire $Ax_j$ de la piste de numéro d'ordre $j$.

On rappelle que les têtes magnétiques de lecture-écriture comprennent un circuit magnétique autour duquel est disposé un enroulement et qui comporte un entrefer. Celui-ci a une forme sensiblement rectangulaire et sa longueur est très supérieure à sa largeur. Elle est de l'ordre de grandeur de la largeur radiale des pistes et des zones de référence (les zones de référence et les pistes ayant la même largeur $1_p$). Pour lire les "données à traiter" d'une piste de numéro d'ordre $j$, aussi bien que les informations de repérage des pistes contenues dans les deux zones de référence $ZRP_{ij}$ et $ZRP_{i(j+1)}$ associées à cette piste, l'entrefer de la tête TEL est disposé perpendiculairement à l'axe magnétique $Ax_j$ de la piste (c'est-à-dire parallèlement à la largeur radiale $1_p$ de celle-ci). Pour que les "données à traiter" de cette piste soient lues (ou écrites) avec le maximum de précision, la tête restant immobile en regard de la piste pendant le temps nécessaire à la lecture de tout ou partie des données qu'elle contient, il faut que l'entrefer soit parfaitement centré sur l'axe magnétique $Ax_j$, frontière entre les deux zones de référence $ZRP_{ij}$ et $ZRP_{i(j+i)}$. On dit également que la tête TEL effectue la lecture ou l'écriture des informations de repérage des pistes contenues dans ces deux zones, en étant disposée à cheval sur celles-ci.

On rappelle qu'un signal électrique logique ne peut prendre que deux valeurs dites "zéro logique" ou "un logique" et qu'un signal électrique analogique varie de façon continue entre deux valeurs limites positive et/ou négative.

Les signaux de lecture de la tête TEL associée à ladite face, sont amplifiés par des circuits amplificateurs avant d'être envoyés:

1— d'une part, aux circuits électroniques de lecture de la mémoire à disques, en ce qui concerne les signaux de lecture amplifiés correspondant aux "données à traiter". Les circuits de lecture prennent en compte ces informations et déterminent la valeur de celles-ci.

2— d'autre part, en ce qui concerne les signaux de lecture amplifiés correspondant aux informations de repérage des pistes,

a) pour les signaux amplifiés correspondant aux adresses, à un dispositif de déplacement de la tête par rapport à la face du disque, tel que celui décrit dans la demande de brevet française No 79.23579 déposée le 21 Septembre 1979 par la Compagnie Demanderesse sous le titre: "Procédé pour déplacer un système mobile par rapport à un support d'informations et dispositif pour le mettre en oeuvre". Le but de ce dispositif est de déplacer radialement la tête d'une piste A où elle se trouve initialement à une piste B dont on veut lire tout ou partie des "données à traiter."

b) pour les signaux amplifiés correspondant aux informations d'asservissement de position, à un dispositif de mesure de la position de la tête par rapport à l'axe de la piste dont on veut lire les informations, tel que celui décrit dans la demande de brevet No 7928421 déposée le 19 Novembre 1979 par la Compagnie Demanderesse sous le titre: "Procédé pour mesurer la position d'une tête de lecture — écriture des informations d'un support par rapport à une position de référence de celui-ci et dispositif pour le mettre en oeuvre".

Pour que les "données à traiter" de la piste (dont on veut lire tout ou partie) soient plus lues par la tête TEL le plus rapidement possible avec le maximum de précision, c'est-à-dire avec un taux d'erreurs le plus faible possible (on rappelle que le taux d'erreurs est le rapport entre le nombre d'informations dont la valeur détectée par le circuit de lecture est erronée et le nombre total d'informations détectées) c'est-à-dire très

inférieur à $10^{-9}$, il importe:

— d'une part, que le temps mis par la tête pour se déplacer de la piste A à la piste B soit le plus court possible, et que la précision du centrage de l'entrefer de la tête au-desdus de la piste B soit la plus grande possible, c'est-à-dire que son entrefer soit maintenu parfaitement à cheval sur l'axe de cette piste B.

— d'autre part, que les circuits de lecture détectent la valeur des "données à traiter" avec le maximum de précision.

On montre alors que, pour satisfaire les conditions énoncées ci-dessus, il est nécessaire que l'amplitude des signaux analogiques délivrés par les dits circuits amplificateurs soit suffisante et maintenue sensiblement constante. En effet:

1°) On montre que l'amplitude des signaux délivrés par la tête TEL, dans les conditions de lecture identiques (même distance entre l'entrefer et la face du disque, même position relative de l'entrefer par rapport à l'information) varie suivant que la tête est en regard d'une piste située soit à la périphérie, soit à l'intérieur du disque: en effet, l'amplitude du signal délivré est d'autant plus élevée que la vitesse de défilement du disque devant celle-ci est plus grande, c'est-à-dire que la tête se trouve en regard d'une piste située à la périphérie du disque.

2°) On montre en outre que, lors du défilement d'une même piste devant la tête TEL, d'une part la distance entre son entrefer et le disque peut varier et d'autre part, la couche magnétique d'enregistrement de la face du disque peut présenter à l'échelle microscopique (pour des dimensions de l'ordre du micron, des défauts d'homogénéité et de planéité. Cela entraîne la conséquence suivant: l'amplitude des signaux délivrés par la tête correspondant aux transitions magnétiques constituant les informations de ladite piste, peut varier sensiblement d'une transition à l'autre.

3°) Dans une mémoire à disques comportant une pluralité de têtes et une pluralité de disques, une seule tête étant associée par exemple, à chaque face des disques, l'amplitude des signaux délivrés par celle-ci, dans des conditions de lecture strictement identiques (même numéro d'ordre de piste, même position relative de l'entefer par rapport à l'information, même distance entre l'entrefer et la face du disque associée à la tête, absence de défauts de la couche magnétique d'enregistrement) varie de l'une à l'autre.

Quelles que soient les variations de l'amplitude des signaux délivrés par la/les tête(s) en fonction des différents facteurs énumérés ci-dessus, aux paragraphes 1°) à 3°), il est nécessaire que les circuits amplificateurs délivrent des signaux dont l'amplitude soit telle que tous les signaux puissent être pris en compte soit par les circuits électroniques de lecture, soit lesdits dispositifs de déplacement ou d'asservissement de position, et la valeur des informations correspondantes déterminées avec un aux d'erreur le plus faible possible. Dans ce but, lesdits circuits amplificateurs sont commandés par un dispositif de commande qui agit sur leur gain de telle sorte que l'amplitude des signaux délivrés par ceux-ci ait un niveau suffisant et reste sensiblement constante.

Dans la pratique courante, le dispositif de commande est commandé par des signaux correspondant à des informations dites "de préambule" enregistrées dans une partie de chaque zone de référence $ZRP_{ij}$.

On sait que, pour enregistrer des informations quelconques sur la face du disque D, on crée au moyen de la tête TEL sur chacune des pistes et sur chacune des zones de référence, une succession de domaines magnétiques élémentaires, de longueur variable répartis sur toute la longueur de chaque piste et de chaque zone ayant alternativement des inductions magnétiques de même module et de sens opposé.

La frontière entre deux domaines magnétiques qui se suivent le long d'une piste d'une zone définit donc un changement de sens de magnétisation appelé également "transition magnétique".

Une telle transition peut avoir deux natures différentes à savoir:

— lorsque la face du disque défile devant la tête et que celle-ci voit défiler successivement un domaine magnétique élémentaire où l'induction est négative puis un domaine magnétique élémentaire où l'induction est positive, on dit que la transition magnétique correspondante est positive.

— lorsque, au contraire, la tête voit défiler successivement un domaine élémentaire magnétique d'induction positive puis un domaine élémentaire magnétique d'induction négative, on dit que la transition magnétique est négative.

Dans la pratique courante, les informations "de préambule" de chaque zone de référence $ZRP_{ij}$ sont enregistrées au début de celles-ci, c'est-à-dire qu'elles sont lues les premières dans le temps (avant les informations de repérage des pistes), lorsque la zone défile devant la tête TEL.

Ces informations sont généralement constituées par une pluralité de transitions magnétiques alternativement de nature différente, qui se suivent à l'intérieur de la zone.

Les signaux correspondants délivrés par la tête sont des impulsions analogiques alternativement de signe contraire qui sont envoyées au dispositif de commande du gain des circuits amplificateurs. Ce dernier détermine la valeur absolue de l'amplitude maximale de ces signaux et la compare à une valeur de référence. Le signal résultant de cette comparaison commande le gain desdits circuits, gain qui est fonction de la valeur et du signe de ce signal. Des dispositifs de commande automatique de gain utilisant un tel procédé sont décrits dans les deux brevets américains No 3 660 821 et No 3 879 674.

De tels dispositifs présentent l'inconvénient suivant: en effet, pour une piste de numéro d'ordre j, et d'une zone de référence d'un secteur $S_i$ à une zone de référence d'un secteur $S_{i+1}$, ladite amplitude maximale peut varier de façon extrêmement sensible pour les raisons indiquées plus haut (défaut de la couche d'enregistrement, variation de distance entre l'entrefer de la tête et la surface du disque): il en résulte une variation sensible du gain du circuit amplificateur et par suite de l'amplitude des signaux de sortie de ceux-ci. On montre alors que le risque d'erreurs dans la prise en compte des informations et dans la détermination de leurs valeurs et ce aussi bien pour les informations de repérage des pistes contenues dans les zones $ZRP_{ij}$ que dans celles des "données à traiter" n'est alors pas négligeable.

La présente invention permet de remédier à ces inconvénients. Elle concerne un procédé pour commander le gain des circuits amplificateurs associés à ladite tête dont le principe consiste à mesurer, sur un intervalle de temps donné, la moyenne du module de la dérivée des signaux délivrés par la tête correspondant aux informations "de préambule", et à la comparer avec une valeur de référence, le gain des circuits amplificateurs étant fonction du résultat de la comparaison.

Selon l'invention, le procédé pour commander le gain des circuits amplifiant les signaux délivrés par une tête de lecture associée à un support dont les informations portées par une pluralité de pistes comprennent un sous-ensemble d'informations "de préambule" inscrites à l'intérieur d'une pluralité de zones de référence, chaque piste étant associée à au moins deux zones, est caractérisé en ce qu'il consiste, pour chaque piste,

— à calculer la moyenne du module de la dérivée du signal délivré par lesdits circuits correspondant aux informations "de préambule" d'au moins une des deux zones associées à ladite piste, sur un intervalle de temps de durée au plus égal au temps de lecture des informations "de préambule" de la zone,

— à mesurer l'écart entre cette moyenne et une valeur de référence,

— à commander le gain desdits circuits en fonction du dit écart.

D'autres caractéristiques et avantages de la présente invention apparaîtront dans la description suivante donnée à titre d'exemple non limitatif et en se référant aux dessins annexés.

Sur ces dessins:

— la figure 1, qui est un ensemble de figures la à 1d montre un exemple préféré de répartition des informations sur la face d'un support d'enregistrement magnétique tel qu'un disque magnétique D;

— la figure 2, montre comment sont réparties les informations à l'intérieur d'une

zone de référence $ZRP_{ij}$ de ladite face du disque D;

— *la figure* 3, illustre un mode d'écriture préféré des informations "de préambule" de chaque zone $ZRP_{ij}$ de ladite face;

— *la figure* 4, montre les parties $PPA_{ij}$ et $PPA_{i(j+1)}$ contenant les informations "de préambule" de deux zones de référence voisines $ZRP_{ij}$ et $ZRP_{i(j+1)}$;

— *la figure* 5, est un schéma de principe du dispositif de mise en oeuvre du procédé de commande du gain des circuits amplifiant les circuits des signaux de lecture de la tête TEL associée à ladite face, selon l'invention;

— *la figure* 6, est un chronogramme de signaux pris en différents endroits dudit dispositif permettant d'illustrer le principe du procédé selon l'invention;

— *la figure* 7, est un schéma plus détaillé d'un partie du dispositif de mise en oeuvre du procédé selon l'invention.

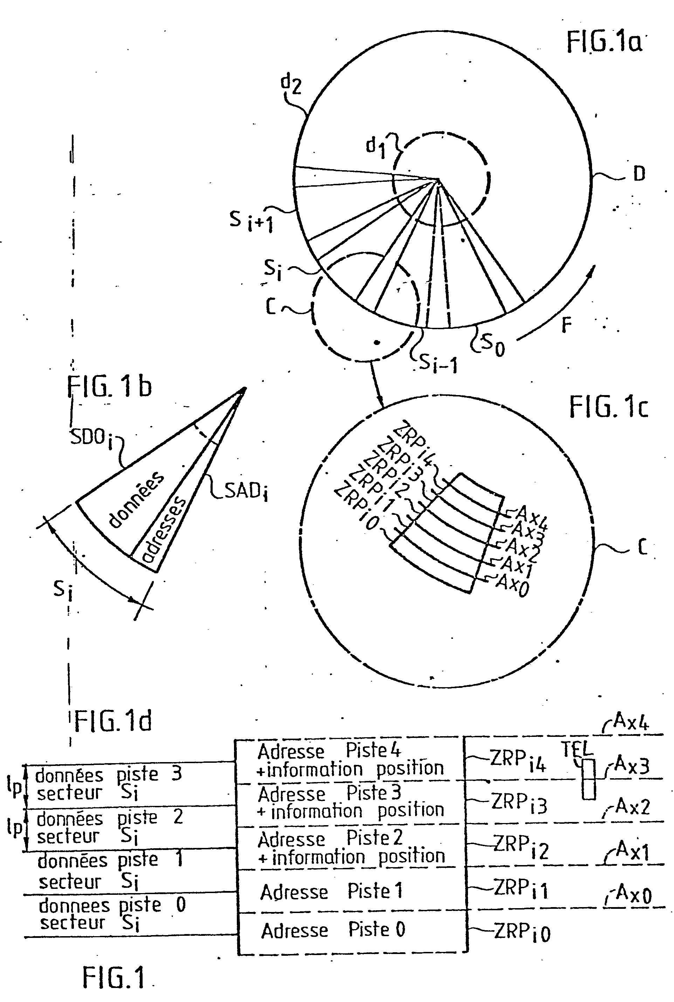

Afin de mieux comprendre les principes de constitution et de fonctionnement du dispositif mettant en oeuvre le procédé selon l'invention, il est utile de faire quelques rappels illustrés par les figures 1a, 1b, 2, 3, 4 montrant comment sont écrites les informations "de préambule" à l'intérieur des zones de référence $ZRP_{ij}$ de la face du disque magnétique D, selon un mode d'écriture préféré desdites informations.

A la figure 1 on a représenté la face du disque D tournant dans le sens de la flèche F, dont la surface utile d'enregistrement est délimitée par des cercles $d_1$ et $d_2$. On définit sur cette face n secteurs circulaires égaux et adjacents $S_0$, $S_1$, ..., $S_i$, $S_{i+1}$, ...$S_{n-1}$. Ainsi qu'on peut mieux le voir à la figure 1b, chaque secteur $S_i$ est divisé en deux parties $SAD_i$, $SDO_i$ où sont enregistrées respectivement d'une part, les informations de repérage des pistes et les informations "de préambule" et d'autre part les "données à traiter" par le système de traitement de l'information auquel appartient la mémoire à disques contenant le disque D. La surface de la partie $SAD_i$ est très inférieure à la surface de la partie $SDO_i$.

Les figures 1c et 1d montrent plus en détail la manière dont sont constituées les parties $SAD_i$ des secteurs $S_i$. Elles sont une vue agrandie de la partie $SAD_i$ du secteur $S_i$ comprise à l'intérieur du cercle C. Chaque partie $SAD_i$ d'un secteur $S_i$ est divisée en $N+1$ zones de référence $ZRP_{i0}$, ... $ZRP_{ij}$, ..., $ZRP_{iN}$. (On rappelle que N est le nombre de pistes d'enregistrement de la face du disque D).

Aux figures 1c et 1d, on n'a représenté pour simplifier que les cinq premières zones de référence $ZRP_{i0}$ à $ZRP_{i4}$ symbolisées par des rectangles. On voit clairement sur ces mêmes figures, que les axes circulaires $Ax_i$ des pistes d'enregistrement coïncident avec les frontières entre les différentes zones de référence $ZRP_{ij}$. A chaque piste de numéro d'ordre j d'axe $Ax_i$ sont associées les zones $ZRP_{ij}$ et $ZRP_{i(j+1)}$, ainsi qu'il a été écrit plus haut. Ainsi, à la piste de numéro d'ordre 0 sont associées les zones $ZRP_{i0}$ et $ZRP_{i1}$, à la piste de numéro d'ordre 1, les zones $ZRP_{i1}$ et $ZRP_{i2}$ et ainsi de suite.

Toute zone $ZRP_{ij}$ contient des informations "de préambule" et les informations de repérage de la piste de numéro d'ordre j (adresse et informations d'asservissement de position). Ainsi, la zone $ZRP_{i0}$ contient les informations "de préambule" et les informations de repérage de la piste de numéro d'ordre 0, la zone $ZRP_{i1}$ les informations "de préambule" et les informations de repérage de la piste de numéro d'ordre 1, la zone $ZRP_{i2}$ les informations "de préambule" et les informations de repérage de la piste de numéro d'ordre 2, et ainsi de suite.

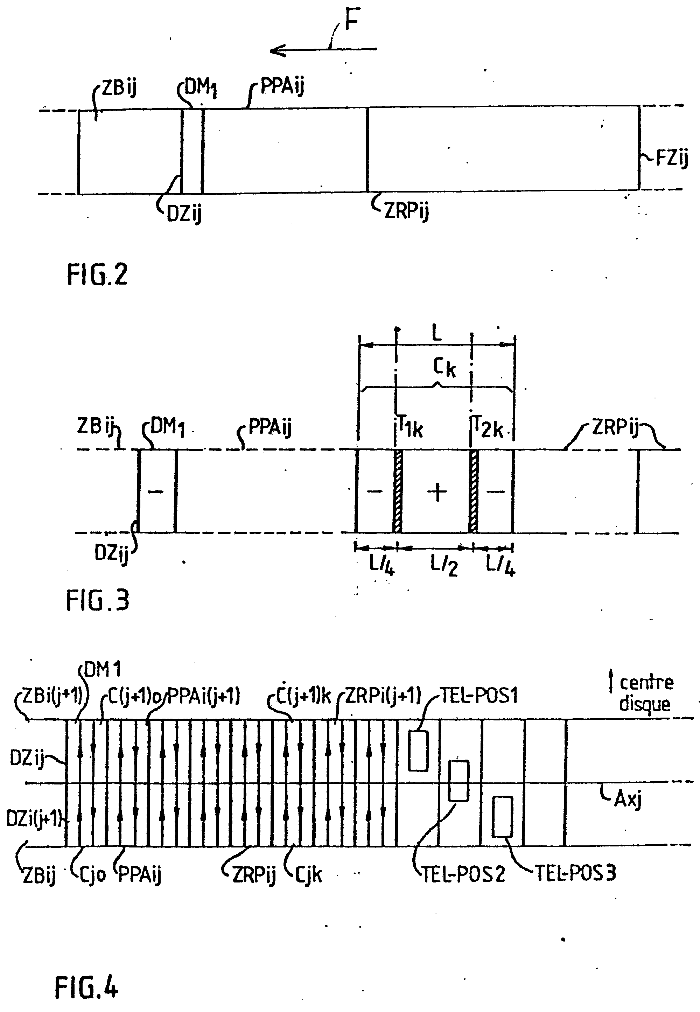

On considère à la figure 2 la zone de référence $ZRP_{ij}$, le sens de défilement du disque D étant indiqué par la flèche F. Les informations "de préambule" sont contenues dans la partie $PPA_{ij}$ de la zone ainsi qu'il a été écrit plus haut, le reste de la zone suivant la partie $PPA_{ij}$ contenant notamment l'adresse de la piste de numéro d'ordre j.

La zone de référence $ZRP_{ij}$ est précédée d'une zone $ZB_{ij}$ dite "zone de blanc" qui suit la partie $SDO_{i-1}$ du secteur $S_{i-1}$ contenant les "données à traiter" de ce secteur. Dan cette zone de blanc $ZB_{ij}$, l'induction magnétique est uniforme et est par exemple nulle.

Le début de la zone $ZRP_{ij}$ est indiqué par la référence $DZ_{ij}$. Il est constitué par un changement de valeur de l'induction magnétique entre la zone $ZB_{ij}$ où l'induction est uniforme et nulle et le premier domaine magnétique $DM_1$ de la zone ZRPij (c'est-à-dire également de la partie $PPA_{ij}$) où l'induction magnétique est par exemple négative. La fin de la zone $ZRP_{ij}$ est indiquée par la référence $FZ_{ij}$.

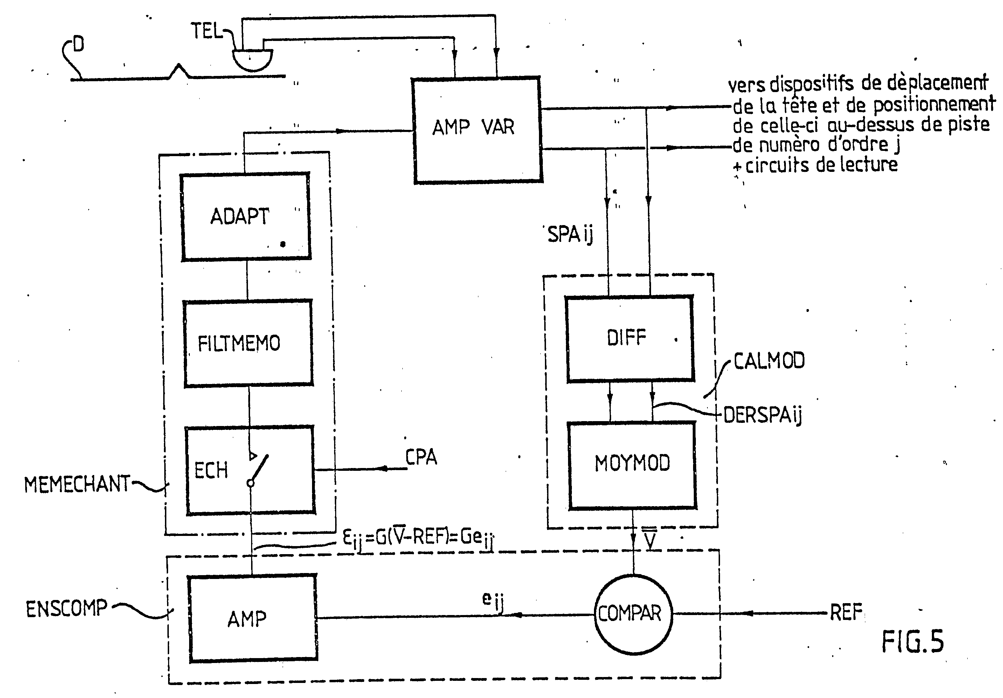

Ainsi qu'on peut le voir à la figure 3, toute information $I_{jk}$ de préambule d'une zone de référence $ZRP_{ij}$ est contenue dans une cellule $C_{jk}$ et définie par la présence d'une double transition magnétique, la première transition $T_{1k}$ étant de signe opposé à la seconde $T_{2k}$. Par exemple, la première transition $T_{1k}$ est positive alors que la seconde $T_{2k}$ est négative. Ainsi qu'on peut le voir à la figure 4 et ainsi qu'il est décrit dans la demande de brevet 78.29847 précitée, toute partie $PPA_{ij}$ d'une zone de référence $ZRP_{ij}$ comprend dans une forme de réalisation préférée, douze cellules de même longueur L contenant chacune une double transition. Le temps de lecture d'une cellule par la tête TEL associée à ladite face est égal à T. Ainsi la partie $PPA_{ij}$ contient les douze cellules $C_{j0}$, $C_{jk}$ à $C_{j11}$ contenant une double transition alors que la partie $PPA_{i(j+1)}$ comprend douze cellules $C_{(j+1)0}$, $C_{(j+1)k}$, à $C_{(j+1)11}$ contenant chacune une double transition. Le domaine $DM_1$ mentionné plus haut appartient à la cellule $C_{j0}$

A la figure 4, on a représenté également les débuts $DZ_{ij}$, $DZ_{i(j+1)}$ des deux zones $ZRP_{ij}$ et $ZRP_{i(j+1)}$. Afin de rendre plus claire cette même figure on a représenté les transitions magnétiques positives par un trait muni d'une flèche

**0 032 324**

dirigée vers le haut, et les transitions magnétiques négatives par un trait muni d'une flèche dirigée vers le bas.

La frontière entre les deux parties $PPA_{ij}$ et $PPA_{i(j+1)}$ (et donc entre les deux zones $ZRP_{ij}$ et $ZRP_{i(j+1)}$) est l'axe magnétique $Ax_j$ de la piste de numéro d'ordre j.

Lorsque l'entrefer de la tête TEL est parfaitement centré en regard de la zone de référence la plus proche du centre du disque, à savoir $ZRP_{i(j+1)}$ à la figure 4 (plus le numéro d'ordre d'une piste est grand, plus elle est proche de centre du disque), et par conséquent en regard de la partie $PPA_{i(j+1)}$, on dit qu'il occupe la position $POS_1$.

Lorsque ce même entrefer est parfaitement centré en regard de la zone de référence la plus éloignée du centre du disque, (à savoir $ZRP_{ij}$ à la figure 4), on dit qu'il occupe la position $POS_3$.

Lorsque la tête est à cheval sur l'axe $Ax_j$ de la piste de numéro d'ordre j, on dit qu'il occupe la position $POS_2$.

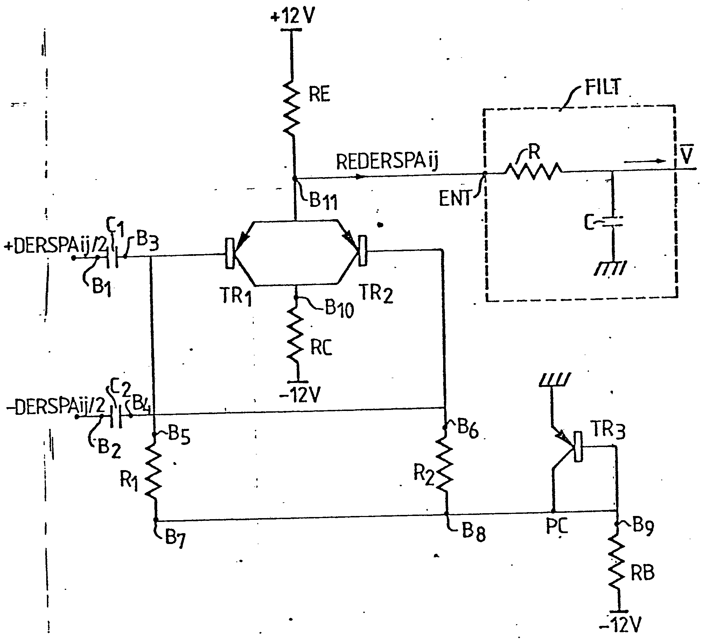

Lorsque les parties $PPA_{ij}$ et $PPA_{i(j+1)}$ défilent devant la tête TEL, celle-ci occupant soit une quelconque des trois positions $POS_1$, $POS_2$, $POS_3$, soit une position quelconque entre les positions $POS_1$ et $POS_2$ ou $POS_2$ et $POS_3$ (on dit alors que la tête TEL est située au voisinage de la frontière $Ax_j$), elle délivre le signal $SPA_{ij}$ qui est un signal périodique de période T (voir figure 6). Lorsqu'on considère deux informations de préambule contenues dans les cellules $C_{jk}$ et $C_{(j+1)k}$ des parties $PPA_{ij}$ et $PPA_{i(j+1)}$, la tête TEL délivre deux impulsions analogiques de signe contraire que ont toujours la même amplitude, même forme et même durée égale T/2 et ce quelleque soit la position occupée par la tête entre les positions $POS_1$ et $POS_3$, y compris celles-ci. En revanche, lorsque les deux parties $PPA_{ij}$ et $PPA_{i(j+1)}$ défilent devant la tête TEL, l'ensemble des impulsions analogiques du signal $SPA_{ij}$ est compris à l'intérieur d'une enveloppe dont la forme idéale est représentée à la figure 6 par l'enveloppe $ENV_1$ représentée en traits pleins: toutes les impulsions positives du signal $SPA_{ij}$ ont alors même amplitude $+AMP$, toutes les impulsions négatives ayant même amplitude $-AMP$ (le signal idéal $SPA_{ij}$ est également représenté en traits pleins). Plus généralement, les impulsions analogiques du signal $SPA_{ij}$ sont comprises à l'intérieur d'une enveloppe du type de celle représentée à la figure 6 en traits interropmus, à savoir $ENV_2$.

Ainsi qu'il a été écrit plus haut, le but du procédé selon l'invention est de commander le gain des circuits amplificateurs des signaux délivrés par la tête TEL, de telle sorte que les signaux délivrés par lesdits circuits aient une amplitude sensiblement constant et suffisante pour qu'ils soient pris en compte sans erreur, soit par les circuits électroniques d'exploitation des données à traiter de la mémoire à disques, soit par le dispositif de déplacement de la tête TEL par rapport à la face du disque à laquelle elle est associée, soit par le dispositif de maintien en position de cette tête au-dessus d'une piste de numéro d'ordre j donnée quelque soit ce numéro.

Selon l'invention, ce procédé consiste pour chaque piste de numéro d'ordre j et dans chaque secteur $S_i$, c'est-à-dire pour les zones de référence $ZRP_{ij}$ et $ZRP_{i(j+1)}$ à:

1°) calculer la moyenne du module de la dérivée du signal $SPA_{ij}$ sur un intervalle de temps de durée au plus égal au temps de lecture de toutes les informations de préambule des parties $PPA_{ij}$ et $PPA_{i(j+1)}$ soit 12T. Ainsi qu'on peut le voir à la figure 6, ce temps de lecture égal à $\tau_{3i}-\tau_{0i}$ ou $\tau_{0i}$ est l'instant où débute ladite lecture et $\tau_{3i}$ l'instant où se termine celle-ci. Dans la pratique, l'intervalle de temps durant lequel on calcule ladite moyenne est égale à $\tau_{2i}-\tau_{1i} < \tau_{3i}-\tau_{0i}$ avec $\tau_{1i} > \tau_{0i}$ et $\tau_{2i} < \tau_{3i}$. L'intervalle $\tau_{2i}-\tau_{1i}$ est égale à n T/2 avec n, entier positif.

Le calcul de la dite moyenne s'effectue:

a) en dérivant le signal $SPA_{ij}$. On obtient ainsi un signal $DERSPA_{ij} = d(SPA_{ij})/dt$, décalé dans le temps par rapport à $SPA_{ij}$. Dans le cas où on suppose que le signal $SPA_{ij}$ est sensiblement sinusoîdal, le signal $DERSPA_{ij}$ est déphasé de $\pi/2$ par rapport au signal $SPA_{ij}$: on peut dire alors que le signal dérivé $DERSPA_{ij}$ est à un facteur de proportionnalité près le signal $SPA_{ij}$ déphasé de $\pi/2$. On montre que, quelle que soit la forme de l'enveloppe $ENV_2$ à l'intérieur de laquelle est inscrit le signal $SPA_{ij}$, le signal dérivé $DERSPA_{ij}$ est inscrit à l'intérieur d'une enveloppe $ENV_3$ dont toutes les impulsions analogique positives ont sensiblement même amplitude $AMP_d$ et toutes les impulsions analogiques négatives $-AMP_d$.

On voit ainsi qu'il est plus avantageux, parce que plus précis, de calculer la moyenne du module du signal $DERSPA_{ij}$ que celle du signal $SPA_{ij}$ (du fait de l'existence de l'enveloppe $ENV_2$ la moyenne du module du signal $SPA_{ij}$ est le plus souvent très faible).

b) en calculant la moyenne du module du signal $DERSPA_{ij}$ que l'on pose égale $\overline{V}$. On écrit également

$$\overline{V} = |(d(SPA)/dt)_{ij}|.$$

2°) à comparer cette moyenne $\overline{V}$ avec une valeur de référence REF donnée. On obtient ainsi une information d'erreur $\varepsilon_{ij}$ proportionnelle à $(\overline{V} - REF)$.

3°) à commander le gain $G_v$ desdits circuits amplificateurs en fonction de la valeur $\varepsilon_{ij}$, de manière à ce que $\varepsilon_{ij}$ tende vers une valeur nulle.

Si $\varepsilon_{ij}$ est supérieure à zéro, on diminue le gain $G_v$. Si $\varepsilon_{ij}$ est inférieure à zéro, on augmente le gain $G_v$. Ainsi on voit qu'en agissant sur le gain $G_v$, on fait bien tendre $\varepsilon_{ij}$ vers zéro: en effet, par exemple, si $\overline{V} > REF$ on diminue $G_v$, ce qui revient à diminuer le module du signal $SPA_{ij}$ et par suite le module de la dérivée de ce signal, c'est-à-dire du signal $DERSPA_{ij}$; en effet, il résulte ce qui a été écrit plus haut concernant ces deux signaux, que le sens de variation de la moyenne du module de chacun de ces signaux est identique.

De préférence, on mémorise et on bloque la valeur de $\varepsilon_{ij}$ obtenue à l'instant $\tau_{2i}$ jusqu'a l'instant $\tau_{1(i+1)}$ où débute la lecture des informations de préambule des zones $ZRP_{(i+1)j}$ et $ZRP_{(i+1)(j+1)}$ du secteur $S_{i+1}$ qui suit le secteur $S_i$ sur le disque D (voir figure 6).

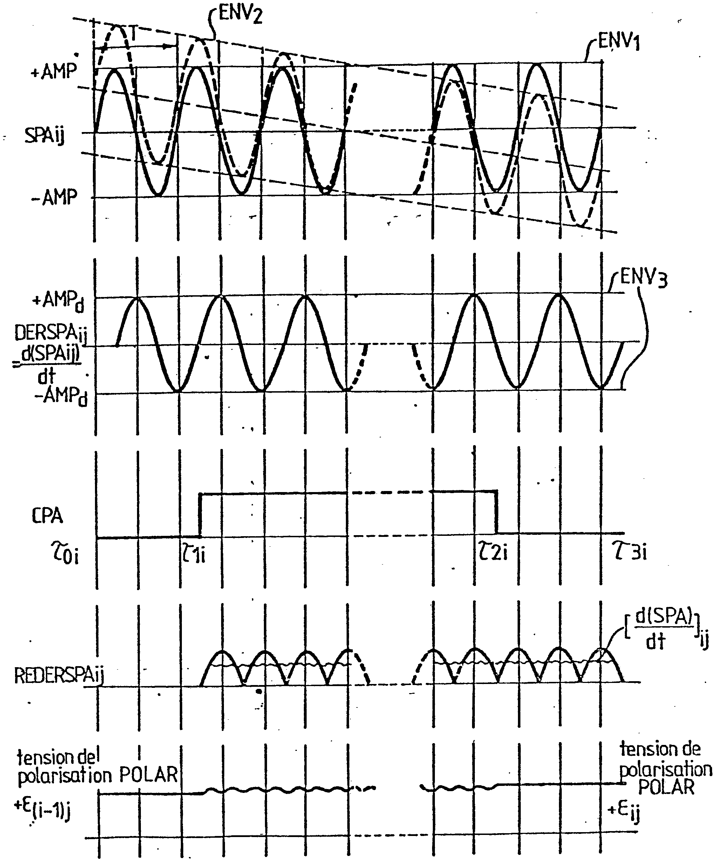

Les éléments constitutifs essentiels du dispositif de mise en oeuvre du procédé selon l'invention sont représentés à la figure 5. Ce sont:

— les circuits AMPVAR amplifiant les signaux délivrés par la tête TEL et délivrant le signal $SPA_{ij}$;

— le calculateur CALMOD de la moyenne $\overline{V}$ du module de la dérivée du signal $SPA_{ij}$;

— les moyens de comparaison ENSCOMP entre la valeur de référence REF et la moyenne $\overline{V}$, que délivrent le signal d'erreurs $\varepsilon_{ij}$.

— la mémoire échantillonnée MEMECHANT de mémorisation et de blocage de la valeur de $\varepsilon_{ij}$. le calculateur CALMOD reçoit le signal $SPA_{ij}$ (voir figure 6) et calcule la moyenne $\overline{V}$ du module de la dérivée $DERSPA_{ij}$ sur l'intervalle de temps $\tau_{2i}$—$\tau_{1i}$. Cette valeur moyenne est envoyée aux moyens de comparaison ENSCOMP qui reçoivent d'autre part, une valeur de référence REF. Ces moyens délivrent un signal égal à $\varepsilon_{ij}$ augmenté d'une tension de polarisation POLAR que l'on suppose nulle pour simplifier. Le signal $\varepsilon_{ij}$ est envoyé à la mémoire échantillonnée MEMECHANT qui la transmet à l'amplificateur AMPVAR. La valeur $\varepsilon_{ij}$ obtenue à l'instant $\tau_{2i}$ est conservée en mémoire et transmise aux amplificateurs AMPVAR jusqu'à l'instant $\tau_{1(i+1)}$ où la tête TEL rencontre les zones $ZRP_{(i+1)j}$ et $ZRP_{(i+1)(j+1)}$ du secteur $S_{i+1}$ qui suit le secteur $S_i$ sur le disque D.

Le calculateur CALMOD comprend: (voir également figure 5)

— les moyens de dérivation DIFF du signal $SPA_{ij}$, qui délivrent le signal $DERSPA_{ij}$;

— les moyens de calcul MOYMOD de la moyenne du module du signal $DERSPA_{ij}$ qui reçoivent ce dernier signal et délivrent le signal $\overline{V}$ aux moyens de comparaison ENSCOMP.

Les moyens de comparaison ENSCOMP comprennent (figure 5):

— un comparateur COMP qui reçoit le signal $\overline{V}$ et la valeur de référence REF. Il délivre le signal $e_{ij}$ égalà $(\overline{V}$—REF);

— un amplificateur AMP à grand gain G qui reçoit le signal $e_{ij}$ et délivre le signal $E_{ij} = G \times e_{ij}$.

La mémoire MEMECHANT comprend:

— un échantillonneur ECHANT qui est un interrupteur fermé entre les instants $\tau_{1i}$ et $\tau_{2i}$ et ouvert à partir de l'instant $\tau_{2i}$ jusqu'à l'instant $\tau_{1(i+1)}$. Il est commandé par le signal CPA;

— une mémoire — filtre FILTMEMO qui mémorise la valeur de $_{ij}$ entre les instants $\tau_{1i}$ et $\tau_{2i}$ et d'autre part mémorise la valeur de $\varepsilon_{ij}$

obtenue à l'instant $\tau_{2i}$ depuis ce dernier jusqu'à l'instant $\tau_{1(i+1)}$;

— un adaptateur d'impédance disposé entre la sortie de la mémoire FILTMEMO et l'entrée des circuits amplificateurs AMP VAR. Cet adaptateur permet d'adapter l'impédance de sortie de la mémoire FILTMEMO à l'impédance d'entrée des circuits AMPVAR, ces deux impédances étant très différentes. Cet adaptateur est désigné par ADAPT.

Les moyens de calcul MOYMOD sont représentés plus en détail à la figure 7. Ils comprennent:

— deux éléments capacitifs $C_1$ et $C_2$;

— une paire de transistors identiques $TR_1$ et $TR_2$;

— un transistor $TR_3$ de type P—N—P;

Les condensateurs $C_1$ et $C_2$ reçoivent respectivement chacun sur leurs bornes $B_1$ et $B_2$ les signaux $+DERSPA_{ij}/2$ et $-DERSPA_{ij}/2$ envoyés par le circuit dérivateur DIFF qui travaille en mode différentiel.

Les bornes $B_3$ et $B_4$ de ces condensateurs sont reliées aux bases des transistors $TR_1$ et $TR_2$ et d'autre part aux bornes $B_5$ et $B_6$ des résistances $R_1$ et $R_2$ qui de préférence, sont identiques.

Les bornes $B_7$ et $B_8$ des résistances $R_1$ et $R_2$ qui sont reliées entre elles, sont connectées au point commun entre les collecteurs et bases du transistor $TR_3$, lui-même relié à la borne $B_9$ de la résistance de base RB. Celle-ci est elle-même connectée à une source de polarisation (non représentée pour simplifier) égale par exemple à —12 Volts.

Les collecteurs des transistors $TR_1$ et $TR_2$ sont reliés entre eux et connectés à la borne $B_{10}$ de la résistance d'émetteur RC, elle-même reliée par ailleurs à une source de polarisation de tension par exemple égale à —12 Volts.

Les transistors $TR_1$ et $TR_2$ ont une résistance d'émetteur commune RE reliée à une source de polarisation positive par exemple égale à +12 Volts. La borne $B_{11}$ de la résistance RE, point commun aux émetteurs de ce transistors, est connectée à l'entrée ENT d'un filtre FILT composé de la résistance R et de la capacité C.

Le transistor $TR_3$ associé aux résistances RB, $R_1$ et $R_2$ assure la polarisation de la paire de transistors $TR_1$—$TR_2$ de telle sorte qu'en dehors de tout signal d'entrée sur leurs bases, la tension du point commun $B_{11}$ est voisine de zéro. L'ensemble constitué par les éléments $TR_1$—$R_1$—$C_1$ d'une part, et $TR_2$—$R_2$—$C_2$ d'autre part, assure le redressement du signal $DERSPA_{ij}$, ce qui revient à calculer le module de ce dernier.

A la sortie dudit ensemble, c'est-à-dire sur le point commun $B_{11}$ on recueille le signal $REDERSPA_{ij}$ (voir figure 6) qui est filtré par le filtre FILT. À la sortie de dernier, on recueille la valeur moyenne $\overline{V}$ du module de la dérivée du signal $SPA_{ij}$.

Dans une forme de réalisation préférée de l'invention l'échantillonneur ECHANT est un transistor à effet de champ, par exemple un transistor DMOS de type SD215 fabriqué par la Société Américaine SIGNETICS.

De préférence, la mémoire filtre FILTMEMO est constituée par une résistance et une capacité, la capacité assurant la fonction de mémoire. Elle est en effet chargée sous une tension égale à $\varepsilon_{ij}$. La résistance associée à cette capacité a une valeur suffisamment grande pour que la capacité mémoire ne se décharge pas. Par suite, l'adaptateur d'impédance ADAPT est nécessaire pour adapter l'impédance de sortie du filtre FILTMEMO qui est très grande, à l'impédance d'entrée des amplicateurs AMPVAR qui est beaucoup plus faible.

**Revendications**

1. Procédé pour commander le gain des circuits (AMPVAR) amplifiant les signaux délivrés par une tête de lecture (TEL) associée à un support (D) dont les informations portées par une pluralité de pistes comprennent un sous-ensemble d'informations de préambule (PPA$_{ij}$) inscrites à l'intérieur d'une pluralité de zones de référence (ZRP$_{ij}$), chaque piste étant associée à au moins deux zones, caractérisé en ce qu'il consiste pour chaque piste:
— à calculer la moyenne ($\overline{V}$) du module de la dérivée (DERSPA$_{ij}$) du signal (SPA$_{ij}$) délivré par lesdits circuits correspondant aux informations de préambule d'au moins une des deux zones associées à ladite piste, sur un intervalle de temps de durée au plus égale au temps de lecture des informations de préambule de la zone;
— à mesurer l'écart (e$_{ij}$, $\varepsilon_{ij}$) entre cette moyenne ($\overline{V}$) et une valeur de référence (REF);
— à commander le gain desdits circuits (AMPVAR) en fonction dudit écart.

2. Procédé selon la revendication 1, caractérisé en ce que on calcule la moyenne de la dérivée dudit signal en:
a) dérivant ledit signal (SPA$_{ij}$) de manière à obtenir un signal dérivé (DERSPA$_{ij}$);
b) redressant ledit signal dérivé de manière à obtenir le module du signal dérivé;
c) calculant la moyenne ($\overline{V}$) du module du signal dérivé.

3. Dispositif de mise en oeuvre du procédé selon l'une des revendications 1 ou 2, caractérisé en ce qu'il comprend:
— des moyens de calcul (CALMOD) du module de la dérivée du signal délivré par lesdits circuits (AMPVAR) correspondant aux informations de préambule (PPA$_{ij}$) d'au moins une desdites zones, recevant ledit signal (SPA$_{ij}$) et délivrant un signal égal à la moyenne ($\overline{V}$) de ce module, qui est envoyé à des moyens de comparaison (ENSCOMP) qui reçoivent également un signal de référence (REF) et délivrent un signal ($\varepsilon_{ij}$) égal à l'écart entre la moyenne du module du signal dérivé et le signal de référence, écart envoyé à des moyens de mémorisation (MEMECHANT), qui mémorisent cet écart et l'envoient auxdits circuits, de manière à faire varier le gain de ceux-ci en fonction dudit écart.

4. Dispositif selon la revendication 3, caractérisé en ce que les moyens de calcul (CALMOD) comprennent:
— des moyens (DIFF) de dérivation dudit signal (SPA$_{ij}$) recevant celui-ci et délivrant ledit signal dérivé (DERSPA$_{ij}$);
— des moyens (MOYMOD) de calcul de la moyenne ($\overline{V}$) du signal dérivé recevant ledit signal dérivé (DERSPA$_{ij}$) et délivrant un signal égal à la moyenne ($\overline{V}$) du module dudit signal dérivé.

**Patentansprüche**

1. Verfahren zur Steuerung der Verstärkung von Schaltungen (AMPVAR), die Signale verstärken, welche von einem Lesekopf (TEL) abgegeben werden, der einem Träger (D) zugeordnet ist, dessen auf einer Mehrzahl von Spuren getragenen Informationen eine Untergruppe von Präambel-Informationen (PPA$_{ij}$) enthalten, die im Inneren einer Mehrzahl von Referenzzonen (ZRP$_{ij}$) aufgezeichnet sind, wobei jede Spur wenigstens zwei Zonen zugeordnet ist, dadurch gekennzeichnet, daß für jede Spur:
— der Mittelwert ($\overline{V}$) des Betrages der Ableitung (DERSPA$_{ij}$) des von den Schaltungen abgegebenen Signals (SPA$_{ij}$) berechnet wird, welches den Präambel-Informationen wenigstens einer der der genannten Spur zugeordneten zwei Zonen entspricht, und zwar über ein Zeitentervall, dessen Dauer höchstens gleich der Zeit zum Auslesen der Präambel-Informationen der Zone ist;
— die Abweichung (e$_{ij}$, $\varepsilon_{ij}$) zwischen diesem Mittelwert ($\overline{V}$) und einem Bezugswert (REF) gemessen wird;
— die Verstärkung der Schaltungen (AMPVAR) in Abhängigkeit von der genannten Abweichung gesteuert wird.

2. Verfahren nach Anspruch 1, dadurch gekennzeichnet, daß der Mittelwert der Ableitung des Signals berechnet wird, indem:
a) das Signal (SPA$_{ij}$) so abgeleitet wird, daß ein abgeleitetes Signal (DERSPA$_{ij}$) erhalten wird;
b) das abgeleitete Signal gleichgerichtet wird, so daß der Betrag des abgeleiteten Signals erhalten wird;
c) der Mittelwert ($\overline{V}$) des Betrages des abgeleiteten Signals berechnet wird.

3. Vorrichtung zur Durchführung des Verfahrens nach Anspruch 1 oder 2, dadurch gekennzeichnet, daß sie enthält:
— Rechenmittel (CALMOD) zum Berechnen des Betrages der Ableitung des von den Schaltungen (AMPVAR) abgegebenen Signals, das den Präambel-Informationen (PPA$_{ij}$) wenigstens einer der Zonen entspricht, wobei die Rechenmittel das Signal (SPA$_{ij}$) empfangen und ein Signal abgeben, das gleich dem Mittelwert (V̄) dieses Betrages ist, und Vergleichereinrichtungen (ENSCOMP) zugeführt wird, die ferner ein Bezugssignal (REF) empfangen und ein Signal (ε_{ij}) abgeben, das gleich der Abweichung zwischen dem Mittelwert des Betrages des abgeleiteten Signals und dem Bezugssignal ist, wobei die Abweichung Speichermitteln (MEMECHANT) zugeführt wird, die diese Abweichung speichern und sie den Schaltungen derart zuführen, daß die Verstärkung derselben in Abhängigkeit von der Abweichung verändert wird.

4. Vorrichtung nach Anspruch 3, dadurch gekennzeichnet, daß die Rechenmittel (CALMOD) enthalten:

— Mittel (DIFF) zum Ableiten des Signals (SPA_{ij}), die dieses Signal empfangen und das abgeleitete Signal (DERSPA_{ij}) abgeben;

— Rechenmittel (MOYMOD) zum Berechnen des Mittelwertes (V̄) des abgeleiteten Signals, welche dieses abgeleitete Signal (DERSPA_{ij} empfangen und ein Signal abgeben, das gleich dem Mittelwert (V̄) des Betrages des abgeleiteten Signals ist.

**Claims**

1. Method of controlling the gain of circuits (AMPVAR) amplifying the signals delivered by a read head (TEL) associated with a carrier (D) of which the information carried by a plurality of tracks comprises a sub-assembly of the preamble information (PPA_{ij}) written within a plurality of reference zones (ZRP_{ij}), each track being associated with at least two zones, characterised in that it consists for each track:

— in calculating the mean (V̄) of the modulus of the derivative (DERSPA_{ij}) of the signal (SPA_{ij}) delivered by the said circuits corresponding to the preamble information of at least one of the two zones associated with the said track, over an interval of time of a duration at the most equal to the time of reading the preamble information of the zone;

— in measuring the difference (e_{ij}, ε_{ij}) between this mean (V̄) and a reference value (REF);

— in controlling the gain of the said circuits (AMPVAR) as a function of the said difference.

2. A method according to claim 1, characterised in that the mean of the derivative of the said signal is calculated by:

a) deriving the said signal (SPA_{ij}) so as to obtain a derived signal (DERSPA_{ij});

b) rectifying the said derived signals so as to obtain the modulus of the derived signal;

c) calculating the mean (V̄) of the modulus of the derived signal.

3. Device for carrying out the method according to either of claims 1 or 2, characterised in that it comprises:

— means for calculating (CALMOD) the modulus of the derivative of the signal delivered by the said circuits (AMPVAR) corresponding to the preamble information (PPA_{ij}) from at least one of the said zones, receiving the said signal (SPA_{ij}) and delivering a signal equal to the mean (V̄) of this modulus, which is fed to comparison means (ENSCOMP) which also receive a reference signal (REF) and deliver a signal (ε_{ij}) equal to the difference between the mean of the modulus of the derived signal and the reference signal, this difference being fed to memory means (MEMECHANT), which memorise this difference and feed it to the said circuits, in a manner to vary the gain of the latter as a function of the said difference.

4. Device according to claim 3, characterised in that the calculating means (CALMOD) comprise:

— means (DIFF) for the derivation of the said signal (SPA_{ij}) receiving the latter and delivering the said derived signal (DERSPA_{ij});

— means (MOYMOD) for calculating the mean (V̄) of the derived signal receiving the said derived signal (DERSPA_{ij}) and delivering a signal equal to the mean (V̄) of the modulus of the said derived signal.

**0 032 324**

FIG.1a

FIG.1b

FIG.1c

FIG.1d

FIG.1

**0 032 324**

$F$

FIG.2

FIG.3

FIG.4

2

FIG.5

vers dispositifs de dèplacement de la tête et de positionnement de celle-ci au-dessus de piste de numèro d'ordre j + circuits de lecture

$\varepsilon_{ij}=G(\overline{V}-REF)=Ge_{ij}$

FIG.6

FIG.7